# EUROPÄISCHE PATENTSCHRIFT

(11) **EP 2 068 447 B1**
(45) Veröffentlichungstag und Bekanntmachung des Hinweises auf die Patenterteilung: **11.04.2012**
(21) Anmeldenummer: 08021154.3
(22) Anmeldetag: 05.12.2008
(51) Int. Cl.: H03K 3/03, G06K 19/077, H03K 5/153

(54) **Elektronikbaugruppe mit organischen Schaltelementen**
Electronics component with organic switching elements
Bloc électronique doté d'éléments de commutation organiques

(30) Priorität: 07.12.2007 DE 102007059231
(43) Veröffentlichungstag der Anmeldung: 10.06.2009
(73) Patentinhaber: PolyIC GmbH & Co. KG, 90763 Fürth (DE)
(72) Erfinder: Krumm, Jürgen, 91056 Erlangen (DE); Ullmann, Andreas, Dr., 90513 Zirndorf (DE)
(74) Vertreter: LOUIS, PÖHLAU, LOHRENTZ

(56) Entgegenhaltungen:
- DE-A1- 10 212 640
- DE-A1-102005 009 819
- BAUDE P F ET AL: "Organic semiconductor RFID transponders" INTERNATIONAL ELECTRON DEVICES MEETING 2003. IEDM. TECHNICAL DIGEST. WASHINGTON, DC, DEC 8 - 10, 2003; [INTERNATIONAL ELECTRON DEVICES MEETING], NEW YORK, NY : IEEE, US, 8. Dezember 2003 (2003-12-08), Seiten 191-194, XP010683989 ISBN: 978-0-7803-7872-8

## Beschreibung

Die Erfindung betrifft eine Elektronikbaugruppe in Form eines mehrschichtigen flexiblen Folienkörpers, welcher eine Trägerfolie aus einem Kunststoff-Material und mehrere elektrische Funktionsschichten umfasst, und die organische Schaltelemente aufweist, insbesondere zur Erzeugung zeitsynchroner Logiksignale und Generierung binärer Datensequenzen.

Die Generierung binärer Datensequenzen findet im Bereich der organischen Elektronik, insbesondere im Bereiche der Polymerelektronik, mittels Taktgeneratoren, Speicherelementen und Logikschaltungen statt. In der Siliziumtechnik ist es üblich, den Schaltakt mittels Taktteilung aus einer Trägerfrequenz eines Übertragungssignals oder der Resonanzfrequenz eines Schwingkreises zu gewonnen. In der Polymerelektronik werden jedoch selbsterregende Ringoszillatoren wie z.B. in dem Dokument DE 102 12 640 A1 beschrieben als Taktgenerator verwendet, denn aufgrund der beschränkten Ladungsträgerbeweglichkeit und den daraus resultierenden Schaltzeiten sind organische Elektronikbaugruppen gegenüber Elektronikbaugruppen in klassischer Siliziumtechnik sehr träge und erlauben daher nicht bei hohen Schaltfrequenzen synchron zu einer Trägerfrequenz zu arbeiten.

Aus der DE 10 2005 009 819 A1 ist ein Ringoszillator aus organischen Bauelementen zur Erzeugung von Taktsignalen bekannt. Ein solcher selbsterregender Ringoszillator basiert auf einfacher zyklischer Hintereinanderschaltung einer ungeraden Anzahl von Invertern, die mit organischen Bauelementen, wie zum Beispiel organischen Feldeffekttransistoren, aufgebaut werden. Nachdem die Schaltzeiten der organischen Bauelemente sehr lange gegenüber Bauelementen auf Siliziumbasis sind und somit u.U. auch die Flankensteilheit der generierten Logiksignale im Vergleich zu der klassischen Elektronik gering ist, ergeben sich Störimpulse, die sich im Lauf der Zeit aufsummieren und die Qualität der generierten Taktsignale deutlich verringern.

Der Erfindung liegt somit die Aufgabe zugrunde, eine verbesserte, auf polymerer Elektronik basierende Elektronikbaugruppe, umfassend einen Taktgenerator anzugeben.

Diese Aufgabe wird durch eine Elektronikbaugruppe in Form eines mehrschichtigen flexiblen Folienkörpers, welcher eine Trägerfolie aus einem Kunststoff-Material und mehrere elektrische Funktionsschichten umfasst, gelöst, wobei die Elektronikbaugruppe einen Taktgenerator mit n seriell hintereinander geschalteten organischen Schaltelementen mit je einem ersten und einen zweiten Eingang und sowie einem ersten und einen zweiten Ausgang aufweist, wobei die organischen Schaltelemente jeweils aus organischen Bauelementen, insbesondere aus organischen Feldeffekttransistoren, aufgebaut sind, die derart miteinander verschaltet sind, dass zwei zueinander invertierte Logiksignale an dem ersten bzw. dem zweiten Ausgang basierend auf einer Differenz der an dem ersten und dem zweiten Eingang anliegenden Logiksignalen generiert werden, wobei der erste und der zweite Ausgang eines jeden Schaltelements mit dem ersten bzw. dem zweiten Eingang der nachfolgenden Schalteinheit verbunden ist, und der erste und der zweite Ausgang des n-ten organischen Schaltelements des Taktgenerators mit dem ersten bzw. dem zweite Eingang des ersten organischen Schaltelements verbunden ist, und wobei ein oder mehr Ausgänge von ein oder mehr der n organischen Schaltelemente mit jeweiligen Eingängen einer ersten elektronischen Schaltung der Elektronikbaugruppe zum Abgriff von einem oder mehreren von Taktsignalen verbunden sind.

Durch die Erfindung wird eine Elektronikbaugruppe mit einem auf polymerer Elektronik basierenden Taktgenerator bereitgestellt, welcher ein deutlich verbessertes Taktsignal bereitstellt. Das "Aufschaukeln" von Störimpulsen, die durch die funktionsinherenten Merkmale organischer, aktiver Bauelemente bedingt sind, wird deutlich verringert bzw. verhindert. Weiterhin hat sich gezeigt, dass ebenfalls die Taktgenauigkeit gegenüber einem Taktgenerator basierend auf einen organischen Ringoszillator verbessert ist. Weitere Vorteile ergeben sich dadurch, dass auch ein aus einer Vielzahl von Schaltelementen aufgebauter Oszillator in einem stabilen Zustand betrieben werden kann und eine beliebige Anzahl n an Schaltelementen zum Aufbau des Taktgenerators verwendet werden kann, also auch diesbezügliche Freiheitsgrade bezüglich der Taktfrequenz bestehen. Weitere Vorteile ergeben sich durch zusätzliche Möglichkeit zur Auskopplung von phasenverschobenen Taktsignalen, die, wie weiter unten auch beschrieben, eine kostengünstige Realisierung schnell schaltender, auf polymerer Elektronik basierende Realisierung von Logikfunkdonen ermöglicht.

Weitere Vorteile der Erfindung ergeben sich durch Ausführungen gemäß den abhängigen Ansprüchen,

Bei einer bevorzugten Ausführung der Erfindung ist vorgesehen, dass der Taktgenerator und die erste elektronische Schaltung derart miteinander verschaltet sind, dass an dem ersten und/oder zweiten Ausgang eines ersten der Schaltelemente erste Taktsignale für die erste elektronische Schaltung abgegriffen werden. An dem ersten und/oder zweiten Ausgang eines zweiten der Schaltelemente, dass sich vom ersten Schaltelement unterscheidenden Schaltelements, werden zweite Taktsignale abgegriffen. Die ersten und die zweiten Taktsignale stellen zueinander phasenverschobene Taktsignale dar, die auf vielfältige Weise in der ersten elektronischen Schaltung für die Generierung binärer Datensequenzen oder für die Ablaufsteuerung von Funktionen verwendet werden können.

Besonders vorteilhaft ist hierbei, wenn sowohl ein oder mehere erste Ausgänge als auch ein oder mehere zweite Ausgänge der Schaltelemente des Taktgenerators mit jeweiligen Eingängen einer ersten elektronischen Schaltung der Elektronikbaugruppe zum Abgriff von ein oder mehr Logiksignalen verbunden sind. Es ist so möglich, in der Elektronikbaugruppe phasensynchrone, zueinander invertierte Signale zu verwenden, die zum einen ermöglichen, die erste elektronische Schaltung mit einer geringeren Anzahl von Schaltstufen aufzubauen, und so die Geschwindigkeit dieser Schaltung zu verbessern, und zum anderen durch die Verringerung der Schaltstufen und dem weiter möglich werdenden, mehr symmetrischen Aufbau der logischen Verknüpfungen in der ersten elektronischen Schaltung eine Verringerung von Störsignalen in der ersten elektronischen Schaltung zu erreichen. Solche Störsignale werden beim Aufbau der ersten elektronischen Schaltung als polymere Elektronik durch das Schaltverhalten organischer aktiver Bauelemente (z.B. organischer FeldeffektTransistoren) bedingt, sobald zwei Signalpfade mit einer unterschiedlichen Anzahl von Schaltstufen oder unterschiedlichen Schaltstufen verknüpft werden, wie dies Untersuchungen gezeigt haben.

Bei einer bevorzugten Ausführung der Erfindung ist vorgesehen, dass der Taktgenerator und die erste elektronische Schaltung derart miteinander verschaltet sind, dass ein oder mehrere erste und/ oder zweite Ausgänge von ein oder mehr der n organischen Schaltelemente des Taktgenerators mit jeweiligen Eingängen der ersten elektronischen Schaltung der Elektronikbaugruppe zum Abgriff von ein oder mehr Taktsignalen verbunden sind. Die für die Ansteuerung des nachfolgenden organischen Schaltelements generierten Signale, die an den ersten und zweiten Ausgängen bereitgestellt werden, werden so ebenfalls als Taktsignale für die erste elektronische Schaltung verwendet, was die Leitungsführung verbessert und die Effektivität der Elektronikbaugruppe erhöht. Weiter ist es auch möglich, dass ein internes Schaltungssignal mindestens eines der organischen Schaltelemente des Taktgenerators als weiteres Ausgangssignal über einen weiteren Ausgang des mindestens einen organischen Schaltelements als Taktsignal zur Verfügung gestellt wird und dieser weitere Ausgang bzw. diese weiteren Ausgänge mit einem jeweiligen Eingang der ersten elektronischen Schaltung der Elektronikbaugruppe zum Abgriff von Taktsignalen verbunden ist. Hierdurch wird eine Entkopplung der Signale erreicht, so dass ein an die jeweilige elektronische Schaltung angepaßtes Taktsignal bereitgestellt werden kann. Diese Ausführungsformen können auch miteinander kombiniert werden.

Weiter hat es sich bewährt, dass organische Schaltelemente je zwei oder mehr erste und jeweils hierzu komplementäre zweite Eingängen sowie zwei oder mehr erste und jeweils hierzu komplementäre zweite Ausgänge aufweisen. Die organischen Schaltelemente sind jeweils aus organischen Bauelementen, insbesondere aus organischen Feldeffekttransistoren, aufgebaut, die derart miteinander verschaltet sind, dass zwei zueinander invertierte Logiksignale an den zueinander komplementären ersten und zweiten Ausgängen basierend auf einer Differenz der an den zueinander komplementären ersten und zweiten Eingängen anliegenden Logiksignalen generiert werden.

Besonders vorteilhaft ist weiter, dass die ein oder mehreren organischen Schaltelemente einen weiteren Eingang zur Zuführung eines Freigabe- oder Blocksignals aufweisen. Durch Anlegen eines entsprechenden Signals an diesen Eingang wird das organische Schaltelement in einen vordefinierten, statischen Zustand versetzt (Blocksignal) oder ein solcher Zustand beendet (Freigabesignal) und die Generierung der Ausgangssignale basierend auf den Eingangssignalen freigegeben. Hierdurch wird ein gezieltes Starten und Stoppen des Taktgenerators sowie eine Synchronisation des Taktgenerators mit einem vorgegebenen Signal ermöglicht.

Bei einer weiteren bevorzugten Ausführung der Erfindung ist vorgesehen, dass das organische Schaltelement zwei Schalteinheiten mit je zwei Eingängen und einem Ausgang aufweist. Die Schalteinheiten weisen organische Bauelemente, insbesondere mit organischen Feldeffekttransistoren, auf. Die Schalteinheiten sind als Logik-Schaltungen ausbildet sind. Zwei Schalteinheiten werden miteinander derart kreuzgekoppelt, dass der Ausgang einer Schalteinheit mit einem Eingang der anderen Schalteinheit verbunden ist und umgekehrt. Vorteilhaft ist, dass durch kreuzgekoppelte Rückkopplung der beiden Schalteinheiten. synchrone Ausgangssignale sichergestellt werden und die Taktgenauigkeit des Taktgenerators verbessert wird.

Es kann bei einer bevorzugten Ausführung der Erfindung vorgesehen sein, dass die erste elektronische Schaltung ebenfalls organische Bauelemente aufweist. Vorteilhaft ist hierbei, dass der Taktgenerator und die erste elektronische Schaltung während der Produktion der Elektronikbaugruppe gleichzeitig parallel gefertigt werden können.

Bei einer weiteren bevorzugten Ausführung der Erfindung ist vorgesehen, dass die erste elektronische Schaltung ein oder mehrere aus organischen Bauelementen aufgebaute Logik-Gatter aufweist. Diesen Logik-Gattern werden zwei oder mehr Logiksignale und/oder invertierter Logiksignale des Taktgenerators zugeführt. Die Logik-Gatter verknüpfen diese zwei oder mehr Logiksignalen und/oder invertierter Logiksignale logisch, wodurch komplexe Funktionen mit sehr geringem Bauelementeaufwand realisiert werden können. Weiter kann vorgesehen sein, dass die erste elektronische Schaltung eine zwei- oder mehrstufige LogikSchaltung ist. Die erste elektronische Schaltung dient zur logischen Verknüpfung drei oder mehr zueinander phasenverschobener Logiksignale und/oder invertierter Logiksignale verschiedener Schaltelemente. Hiermit wird vorteilhaft ermöglicht, dass die erste elektronische Schaltung auch komplexe Operationen, wie zum Beispiel Addition, Subtraktion, Multiplikation und/oder Division, zur Erzeugung binär Datensequenzen implementieren kann.

Bei einer bevorzugten Ausführung der Erfindung ist vorgesehen, dass die erste elektronische Schaltung zwei oder mehr Speicherelemente aufweist. Diese zwei oder mehr Speicherelemente können hierbei als permanente, mittels passiver Bauelemente realisierte Speicherelemente ausgebildet sein oder als Speicherelemente, die aus mehreren miteinander verschalteten aktiven Bauelementen ausgebildet sind. Die zwei oder mehr Speicherelemente werden jeweils mittels eines zugeordneten Logiksignals ausgelesen. Vorzugsweise werden permanente Speicherelemente, d. h. Speicherelemente deren Speicherinhalt nur ein einziges Mal festgelegt werden kann, zum Beispiel bei der Produktion, verwendet, um binäre Daten sicher vor unbefugter Manipulation in die Elektronikbaugruppe zu implementieren und diese so zu individualisieren.

Es kann bei einer bevorzugten Ausführung der Erfindung vorgesehen sein, dass die Elektronikbaugruppe ein flexibles Folienelement ist. Das flexible Folienelement dient als Sicherungselement, insbesondere für Wertdokumente und Waren. Vorzugsweise ist das flexible Folienelement in Form eines RFID-Transponders ausgebildet.

Bei einer bevorzugten Ausführung der Erfindung ist vorgesehen, dass die Elektronikbaugruppe weiter eine Antenne und einen mit der Antenne gekoppelten Modulator als zweite elektronische Schaltung aufweist. Ein Steuereingang der zweiten elektronischen Schaltung ist mit einem Ausgang der ersten elektronischen Schaltung verbunden, so dass der Modulator von der ersten elektronischen Schaltung gesteuert wird, Der Modulator ist hierbei beispielsweise mit der Antenne zur Lastmodulation eines auf die Resonanzfrequenz des Antennenschwingkreises abgestimmtes Trägersignals verschaltet, so dass durch Lastmodulation auf dieses Trägersignal - gesteuert von der ersten elektronischen Schaltung - ein Signal aufmoduliert werden kann. Bei der ersten elektronischen Schaltung handelt es sich hierbei vorzugsweise um eine Logikschaltung, die eine binäre Sequenz erzeugt, welche mittels des Modulators auf ein Trägersignal aufmoduliert wird.

Im Folgenden wird die Erfindung anhand von Ausführungsbeispielen in Verbindung mit Figuren näher beschrieben. Dabei zeigen:
- Figur 1:: Eine schematische Darstellung zur Verdeutlichung der Funktionsweise einer erfindungsgemäßen Elektronikbaugruppe mit Taktgenerator.
- Figur 2a:: Eine erste Ausführungsform eines organischen Schaltelements des Taktgenerators, bestehend aus mehreren organischen Schalteinheiten.
- Figur 2b:: Eine zweite Ausführungsform eines organischen Schaltelements des Taktgenerators, bestehend aus mehreren organischen Schalteinheiten.
- Figur 3a:: Eine schematische Darstellung einer organischen Schalteinheit für den Aufbau eines organischen Schaltelements nach Fig. 2a oder Fig. 2b.
- Figur 3b:: Eine schematische Schnittdarstellung der organischen Schalteinheit nach Fig. 3b
- Figur 4.: Eine schematische Darstellung eines RFID-Transponders basierend auf einer erfindungsgemäßen Elektronikbaugruppe.

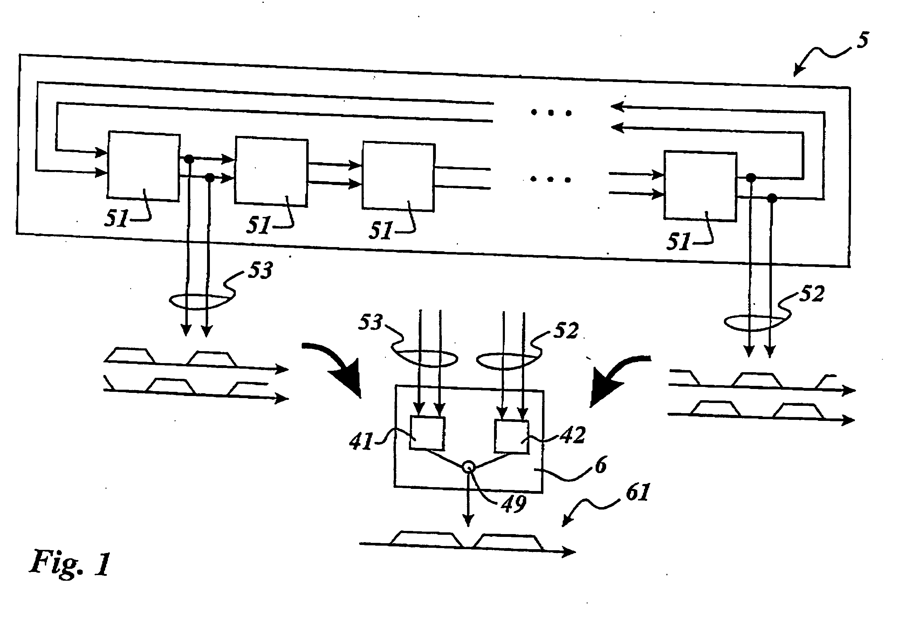

Figur 1 zeigt eine schematische Darstellung der Funktionsweise der erfindungsgemäßen Elektronikbaugruppe 10.

Bei der Elektronikbaugruppe 10 handelt es sich um einen flexiblen, mehrschichtigen Folienkörper mit einer Trägerfolie und ein oder mehreren elektrischen Funktionsschichten. Die elektrischen Funktionsschichten des Folienkörpers bestehen aus elektrisch leitfähigen Schichten, halbleitenden Schichten und/oder Isolationsschichten. Diese Schichten sind zu mindestens teilweise in strukturierter Form, übereinander angeordnet, wobei die Trägerfolie als Trägersubstrat dient, auf dem die elektrischen Funktionsschichten in einem kontinuierlichen Verfahren, einem Rolle zu Rolle Verfahren, hergestellt werden. Die Trägerfolie besteht aus einer Kunststoff-Folie einer Dicke von 12 bis 100 µm. Die Trägerfolie besteht so beispielsweise aus einer biaxial gereckten PET Folie einer Dicke von 24 µm.

Neben diesen elektrischen Funktionsschichten umfasst der mehrschichtige Folienkörper optional noch ein oder mehrere weitere Schichten, insbesondere Tragerschichten oder Substratschichten, Schutzschichten, Dekorlagen, Haftvermittlungsschichten und/ oder Kleberschichten. Die elektrisch leitfähigen Funktionsschichten bestehen vorzugsweise aus einer leitfähigen, strukturierten Metallisierung, vorzugsweise aus Gold oder Silber. Diese Funktionsschichten können auch aus einem sonstigen anorganischen elektrisch leitfähigen Material bestehen, beispielsweise aus Indium-Zinn-Oxid oder aus einem organischen leitfähigen Material, insbesondere einem leitfähigen Polymer bestehen, beispielsweise aus Polyanilin oder Polypyrol. Organisch-halbleitenden Schichten können aus konjugierten Polymeren, wie Polythiophenen, Polythienylenvinylenen oder Polyflurenderivaten bestehen, die als Lösung durch Spin-Coating, Rakeln oder Bedrucken aufgebracht werden. Als organische Halbleiterschicht sind auch sogenannte "Small Moleküls", d. h. Oligomere wie Sexithiophen oder Pentacen, geeignet, die mittels Vakuumtechnik aufgedampft werden. Die halbleitenden Funktionsschichten können auch aus einem anorganischen halbleitenden Material oder aus Nanopartikeln mit halbleitenden Eigenschaften bestehen, die beispielsweise in einer Lösung aufgebracht, aufgedampft oder aufgesputtert werden. Die elektrischen Funktionsschichten werden j bevorzugt durch ein Druckverfahren (Tiefdruck, Siebdruck, Tampondruck) partiell- oder musterförmig strukturiert aufgebracht. Hierzu sind vorzugsweise organische Materialien für die Schichten vorgesehenen, die als lösbare Polymere ausgebildet sind. Alternativ könne jedoch auch, wie oben bereits beschrieben, anstatt der lösbaren Polymere auch lösbare Oligomere vorgesehen sein.

Die einzelnen elektrischen Funktionsschichten Schichten weisen hierbei eine Schichtdicke von 5 nm bis 300 nm auf.

Diese elektrischen Funktionsschichten des Folienkörpers sind so ausgebildet, dass sie die im Folgenden beschriebenen Funktionen realisieren.

Figur 1 zeigt einen erfindungsgemäßen Taktgenerator 5, Der Taktgenerator weist n zyklisch hintereinander geschaltete organische Schaltelemente 51 auf, d. h. das erste organische Schaltelement wird als n+1-tes organische Schaltelement behandelt. Diese Schaltelemente 51 weisen je einen ersten Eingang und einen zweiten Eingang, sowie einen ersten Ausgang und einen zweiten Ausgang auf. Hierbei wird jeweils der erste Ausgang mit dem ersten Eingang des nächsten Schaltelements 51 verbunden. In gleicher Weise werden die zweiten Eingänge und Ausgänge der organischen Schaltelemente 51 miteinander verschaltet. Somit ergeben zwei in gleicher Richtung umlaufende Logiksignale. Die einzelnen organischen Schaltelemente 51 sind jeweils aus organischen Bauelementen, insbesondere aus organischen Feldeffekttransistoren, aufgebaut. Unter organischem Schaltelement wird hierbei ein aus organischen Bauelementen bestehendes Schaltelement verstanden. Unter organischen Bauelementen sind hierbei elektrische Bauelemente zu verstehen, die überwiegend aus organischem Material bestehen, die insbesonders zu mehr als 90% (Gewichtsprozent) aus organischem Material bestehen. Wie bereits oben ausgeführt werden organischen Bauelemente von Bereichen eines von einem Trägersubstrat und elektrischen Funktionsschichten gebildeten Mehrschichtkörpers gebildet, wobei die elektrischen Funktionsschichten aus einer Lösung aufgebracht, aber auch aufgedampft, aufgesputtert, auflaminiert oder als Übertragungslage einer Transferfolie abgeprägt sein können. Aus einer Lösung aufgebrachte elektrische Funktionsschichten werden beispielsweise durch Drucken, Giesen, Sprühen oder Aufrakeln aufgebracht. Die elektrischen Funktionsschichten werden hierbei in einem kontinuierlichen Prozeß, vorzugsweise in einem Rolle zu Rolle Verfahren, auf das in Form einer flexiblen Folienbahn ausgebildete Trägersubstrat aufgebracht- im Gegensatz zur klassischen Halbleiterbauelementen, die durch Dotierung von Bereichen eines Silizium-Wafers gefertigt werden. Die organischen Bauelemente sind dabei derart miteinander verschaltet, dass zwei zueinander invertierte Logiksignale an den Ausgängen basierend auf einer Differenz der an den beiden Eingängen anliegenden Logiksignale generiert werden. Diese beiden zueinander invertierten ausgangsseitigen Logiksignale sind somit zueinander synchron.

An den Ausgängen 52, 53 der organischen Schaltelemente 51 können die zueinander invertierten Logiksignale abgegriffen werden. In Figur 1 werden nach dem ersten Schaltelement 51 erste zueinander invertierte Logiksignale und nachdem letzten Schaltelement 51 zweite zueinander invertierte Logiksignale abgegriffen und einer ersten elektronischen Schaltung 6 zugeführt. Der zeitliche Verlauf der zueinander invertierten Logissignale mit symmetrischen, langsam ansteigenden und langsam abfallenden, Flanken ist in Figur 1 schematisch dargestellt. Die ersten und die zweiten zueinander invertierten Logiksignale sind zueinander phasenverschoben.

Die erste elektronische Schaltung 6 ist ebenso wie der Taktgenerator 5 mit organischen Bauelementen aufgebaut. Die erste elektronische Schaltung 6 umfasst zwei Speicherelemente 41, 42. Die zueinander invertierten Logiksignale der Ausgänge 53 der ersten organischen Schalteinheit 51 werden dem ersten Speicherelement 41, und zueinander invertierte Logiksignale der Ausgänge 52 der n-ten organischen Schalteinheit 51 werden dem zweiten Speicherelement 42 zugeführt. Das erste Speicherelement 41 ist derart gestaltet, dass das Logiksignal des zweiten Ausgangs des ersten Schaltelements 51 ausgelesen wird und das zweite Speicherelement 42 ist derart gestaltet, dass das Logiksignal des ersten Ausgangs des letzten Schaltelements 51 ausgelesen wird. Die so ausgelesenen Logiksignale werden anschließend mittels eines ODER-Gatters 49 verknüpft und als Logiksignal 61 über einen Ausgang der ersten elektronischen Schaltung bereitgestellt. Das ODER-Gatter 49 der ersten elektronischen Schaltung 6 ist dabei ebenso aus organischen Bauelementen aufgebaut.

Besonders vorteilhaft an dem erfindungsgemäßen Taktgenerator 5 ist, dass durch den differenziellen Eingang ein Aufschaukeln von Störimpulsen schon im Ansatz vermieden wird. Weiter stehen zwei synchrone zueinander invertierte Logiksignale zur Verfügung, so dass je nach Bedarf ohne Invertierung ein geeignetes Logiksignal ausgewählt werden kann.

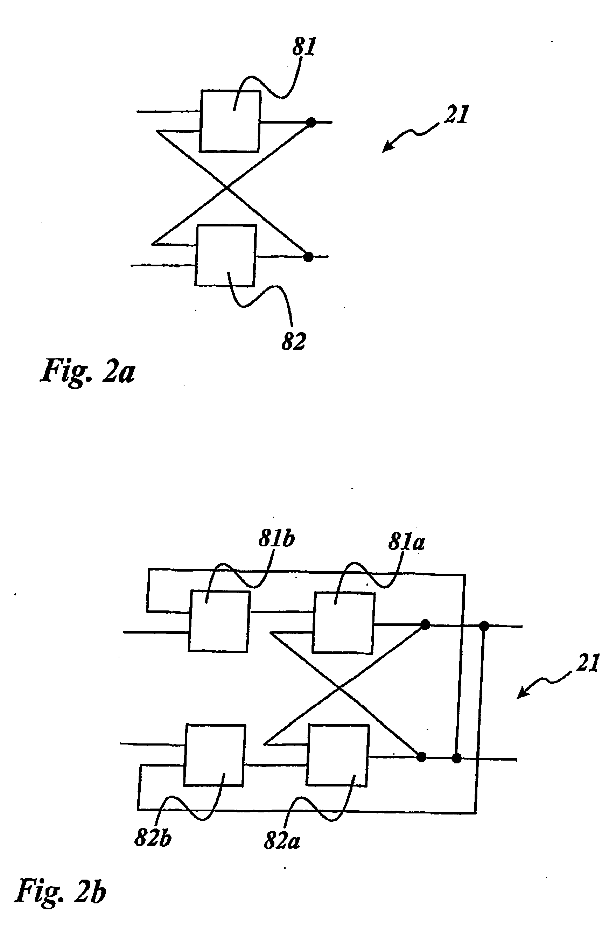

Die Figuren 2a und 2b zeigen schematisch zwei Varianten der organischen Schaltelemente 21.

In Figur 2a ist eine erste Ausführungsform des erfindungsgemäßen Schaltelements 21 gezeigt. Figur 2a zeigt zwei organische Schalteinheiten 81, 82, die aus organischen Bauelementen, insbesondere aus organischen Feldeffekttransistoren, gleich aufgebaut sind. Diese Schalteinheiten 81, 82 weisen je zwei Eingänge und je einen Ausgang auf. Diese beiden Schalteinheiten 81, 82 sind miteinander kreuzgekoppelt, so dass der eine Eingang der einen Schalteinheit 81 mit dem Ausgang der anderen Schalteinheit 82 gekoppelt ist und umgekehrt. Durch die langsamen Schaltzeiten und die kreuzweise Rückkopplung, ergibt sich vorteilhaft ein genau definierter Verzögerungs- und Speichexeffekt, so dass Störsignale geglättet werden und synchrone Logiksignale am Ausgang der Schalteinheit 21 bereitgestellt werden.

In Figur 2b ist eine weitere Variante eines erfindungsgemäßen Schaltelements 21 gezeigt. Hierbei handelt es sich um eine einmal iterierte Variante der Ausführungsform entsprechend der Figur 2a. In Figur 2b entsprechen die Schalteinheiten 81a und 82a den Schalteinheiten 81 beziehungsweise 82 der Ausführung entsprechend der Figur 2a. Diese Schalteinheiten 81a und 82a sind analog zur Ausführung entsprechend der Figur 2a kreuzgekoppelt. Bei der zweiten Variante werden nun noch zwei weitere gleiche organische Schalteinheiten 81b und 82b vorgeschaltet und wieder ausgangseitig kreuzgekoppelt. Vorteilhaft bei dieser zweiten Ausführungsvariante des Schaltelements ist, dass gegenüber der ersten Ausführung eine höhere Stabilität der zueinander invertierten Logiksignale erhalten wird.

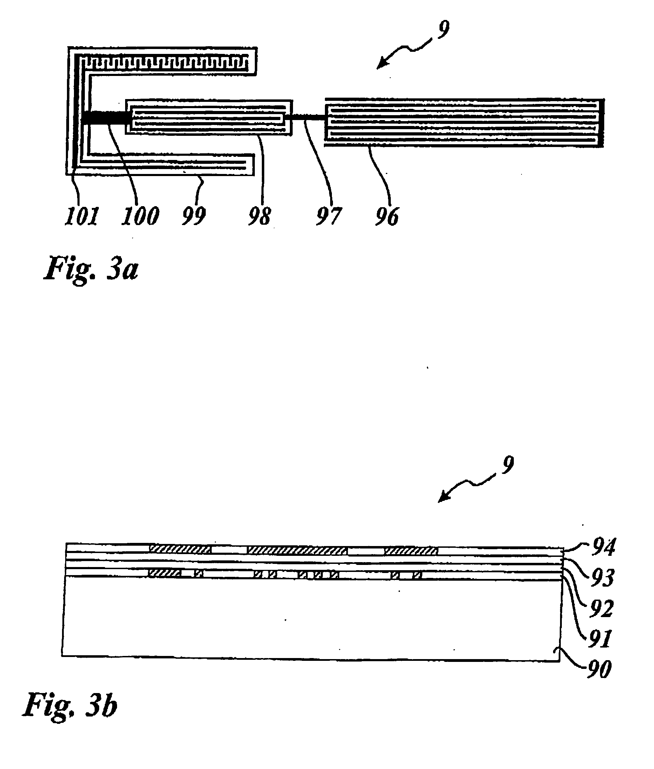

Anhand der Figuren Fig. 3a und Fig. 3b wird nun der prinzipielle Aufbau der Schalteinheiten 81, 81a, 82 und 82a erläutert. Fig. 3a zeigt eine Draufsicht auf eine Schalteinheit 9 mit den Leitexstruktuxen 96 bis 101. Fig. 3b zeigt eine Schnittdarstellung der Schalteinheit 9 mit dem Trägersubstrat 90 und den elektrischen Funktionsschichten 91 bis 94. Bei den elektrischen Funktionsschichten 91 und 94 handelt es sich um elektrisch leitende Funktionsschichten, die wie in Fig. 3a und Fig. 3b angedeutet strukturiert sind. Bei der elektrischen Funktionsschicht 92 handelt es sich um eine elektrisch halbleitende Funktionsschicht, die vorzugsweise auch in strukturierter Form vorliegt. Bei der Funktionsschicht 93 handelt es sich um eine Isolationsschicht. Bezüglich der Verfahrensaufbringung dieser Schichten, der Schichtdicken und für diese Schichten zu verwendenden Materialien wird auf die vorgehenden Ausführungen verwiesen.

Die Leiterstrukturen 96 bis 101 sind wie in Fig. 3 verdeutlicht in der parallel zur Oberfläche des Trägersubstrats 90 liegenden Ebene ausgeformt. Die Leiterstruktureo 96, 97, 100 und 101 sind in der Funktionsschicht 91 ausgebildet. Die Leiterstrukturen 98 und 99 sind in der Funktionsschicht 94 ausgebildet. Die Leiterstruktur 96 ist mit der Versorgungsspannung verbunden. Die Leiterstruktur 97 greift fingerförmig in die Leiterstrukturen 96 und 101 ein, wie dies in Fig. 3a verdeutlicht ist. An der Leiterstruktur 97 wird das Ausgangssignal abgegriffen. Die Leiterstruktur 100 greift zum einen fingerförmig in die Leiterstruktur 98 ein und mit ihrem oberen Leitungszweig fingerförmig in die Leiterstruktur 101 ein, wie dies in Fig. 3a dargestellt ist. Die Leiterstruktur 101 ist mit der zweiten Versorgungsspannung, beispielsweise mit Masse verbunden. An der Leiterstruktur 98 wird das erste Eingangssignal und an der Leiterstruktur 99 das zweite Eingangssignal angelegt. Die halbleitende elektrische Funktionsschicht ist vorzugsweise im Überdeckungsbereich der Leiterstrukturen 98 und 99 vorgesehen und überdeckt weiter den Bereich, in den die Leiterstrukturen 96 und 97 fingerförmig ineinandergreifen (und bilden dort einen Auator aus).

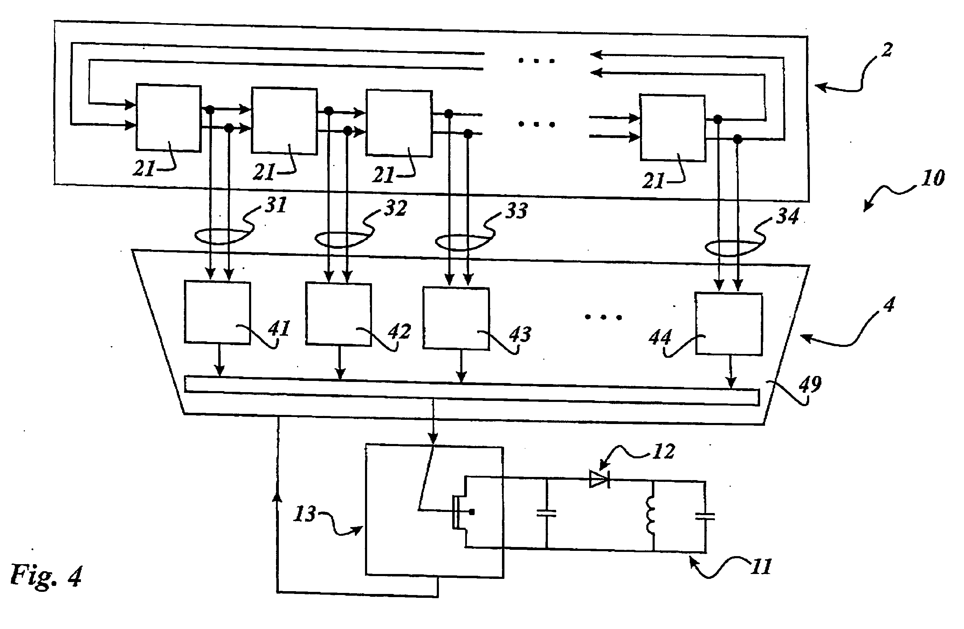

Figur 4 zeigt eine schematische Darstellung eines RFID-Transponders basierend auf einer erfindungsgemäßen Elektronikbaugruppe 10. Der RFID-Transponder 10 ist hierbei vollständig mit organischen Bauelementen realisiert.

Die Elektronikbaugruppe 10 weist einen Taktgenerator 2, eine erste elektronische Schaltung 4, eine zweite elektronische Schaltung 13 als Modulator, einen Gleichrichter 12, sowie einen Antennenschwingkreis 11 auf.

Der Taktgenerator 2 ist entsprechend zu dem Taktgenerator 5 beschrieben in Figur 1 aus gebildet. Der Taktgenerator umfasst n zyklisch hintereinander geschaltete Schaltelemente 21. An jedem ersten und zweiten Ausgang 31, 32, 33, und 34 der organischen Schaltelemente 21 werden die zueinander invertierten Logiksignale abgegriffen, die den Speicherelementen 41, 42, 43, beziehungsweise 44 der ersten elektronischen Schaltung 4 übertragen werden. Logiksignale verschiedener Ausgänge 31, 32, 33, und 34 sind zueinander jeweils phasenverschoben. Die Speicherelemente 41, 42, 43, und 44 sind permanent ausgebildet in Form einer elektrisch leitenden oder nichtleitenden Verbindung. Diese mittels Logiksignale ausgelesen Speicherelement 41, 42, 43, und 44 werden anschließend mit einem mehrstufigen Logik-Gatter 49 in Form einer binären Datensequenz an den Modulator 13 übermittelt. Die binäre Datensequenz dient zur Ansteuerung des organischen Feldeffekttransistors des Modulators 13, Der Modulator 13 ist mit dem Antennenschwingkreis 11 über den zwischengeschaltetem Gleichrichter 12 gekoppelt und bildet so eine veränderliche Last des Antennenschwingkreises. Der Gleichrichter 12 ist mit einer organischen Halbleiterdiode realisiert. Der Antennenschwingkreis 11 umfasst eine Antennen-Spule und einen Kondensator. Ferner wird die Stromversorgung des Taktgenerators und der ersten elektronischen Schaltung 4 am Kondensator abgegriffen. Somit lässt sich mit wenigen organischen Bauteilen ein RFID-Transponder mit hoher Signalqualität realisieren.

## Patentansprüche

1. Elektronikbaugruppe (10) in Form eines mehrschichtigen flexiblen Folienkörpers, welcher eine Trägerfolie aus einem Kunststoff-Material und mehrere elektrische Funktionsschichten umfasst, wobei die Elektronikbaugruppe (10) einen Taktgenerator (2, 5) mit n seriell hintereinander geschalteten organischen Schaltelementen (21, 51) mit je mindestens einem ersten und einem hierzu komplementären zweiten Eingang sowie mindestens einem ersten und einem hierzu komplementären zweiten Ausgang aufweist, wobei der erste und der zweite Ausgang eines jeden Schaltelements (21, 51) mit dem ersten bzw. dem zweiten Eingang des nachfolgenden organischen Schaltelements (21, 51) verbunden ist, wobei der erste und der zweite Ausgang des n-ten organischen Schaltelements (21,51) mit dem ersten bzw. dem zweite Eingang des ersten organischen Schaltelements (21, 51) verbunden ist, und wobei ein oder mehr Ausgänge von ein oder mehr der n organischen Schaltelemente (21, 51) des Taktgenerators (2, 5) mit jeweiligen Eingängen einer ersten elektronischen Schaltung (4, 6) der Elektronikbaugruppe (10) zum Abgriff von ein oder mehr Taktsignalen verbunden sind,
**dadurch gekennzeichnet,**
**dass** die organischen Schaltelemente (21, 51) jeweils aus organischen Bauelementen, insbesondere aus organischen Feldeffekttransistoren, aufgebaut sind, die derart miteinander verschaltet sind, dass zwei zueinander invertierte Logiksignale an dem ersten bzw. dem zweiten Ausgang basierend auf einer Differenz der an dem ersten und dem zweiten Eingang anliegenden Logiksignalen generiert werden, wobei jedes organische Schaltelement (21, 51) mindestens zwei Schalteinheiten (81, 82) mit je zwei Eingängen und mindestens einem Ausgang aufweist, wobei die Schalteinheiten (81, 82) aus organischen Bauelementen, insbesondere mit organischen Feldeffekttransistoren, als Logik-Schaltungen ausbildet sind und die zwei Schalteinheiten (81, 82) miteinander derart kreuzgekoppelt sind, so dass ein Ausgang einer Schalteinheit (81) mit einem Eingang der anderen Schalteinheit (82) verbunden ist und umgekehrt..

2. Elektronikbaugruppe (10) nach Anspruch 1,
**dadurch gekennzeichnet,**
**dass** der Taktgenerator (2, 5) und die erste elektronische Schaltung (4, 6) derart miteinander verschaltet sind, dass ein oder mehrere erste und/ oder zweite Ausgänge von ein oder mehr der n organischen Schaltelemente (21, 51) des Taktgenerators (2, 5) mit jeweiligen Eingängen der ersten elektronischen Schaltung (4, 6) der Elektronikbaugruppe (10) zum Abgriff von ein oder mehr Taktsignalen verbunden sind.

3. Elektronikbaugruppe (10) nach Anspruch 2,
**dadurch gekennzeichnet,**
**dass** der Taktgenerator (2, 5) und die erste elektronische Schaltung (4, 6) derart miteinander verschaltet sind, dass an dem ersten und/oder zweiten Ausgang (31, 52) eines ersten der organischen Schaltelemente (21, 51) erste Taktsignale für die erste elektronische Schaltung (4, 6) abgegriffen werden und an dem ersten und/oder zweiten Ausgang (32, 33, 34, 35, 53) eines zweiten, sich vom ersten Schaltelement unterscheidenden Schaltelements (21, 51) zweite, gegenüber den ersten Taktsignalen phasenverschobene Taktsignale für die erste elektronische Schaltung (4, 6) abgegriffen werden.

4. Elektronikbaugruppe (10) nach Anspruch 2 oder 3,
**dadurch gekennzeichnet,**
**dass** sowohl ein oder mehrere erste Ausgänge als auch ein oder mehrere zweite Ausgänge der organischen Schaltelemente des Taktgenerators (2, 5) mit jeweiligen Eingängen der ersten elektronischen Schaltung (4, 6) der Elektronikbaugruppe (10) zum Abgriff von ein oder mehr Taktsignalen verbunden sind.

5. Elektronikbaugruppe nach einem der Ansprüche 1 bis 4,
**dadurch gekennzeichnet,**
**dass** ein internes Schaltungssignal mindestens eines der organischen Schaltelemente des Taktgenerators als weiteres Ausgangssignal über einen weiteren Ausgang des mindestens einen organischen Schaltelements mit einem jeweiligen Eingang der ersten elektronischen Schaltung der Elektronikbaugruppe zum Abgriff von ein oder mehr Taktsignalen verbunden ist.

6. Elektronikbaugruppe nach einem der vorgehenden Ansprüche,
**dadurch gekennzeichnet,**
**dass** ein oder mehrere der organischen Schaltelemente einen weiteren Eingang zur Zuführung eines Freigabe- oder Blocksignals aufweisen.

7. Elektronikbaugruppe (10) nach einem der vorangehenden Ansprüche,
**dadurch gekennzeichnet,**
**dass** die erste elektronische Schaltung (4, 6) ein oder mehrere aus organischen Bauelementen aufgebaute Logik-Gatter aufweist, welche die zugeführten zwei oder mehr Taktsignale logisch zu einem Ausgangssignal verknüpfen.

8. Elektronikbaugruppe (10) nach einem der vorgehenden Ansprüche,
**dadurch gekennzeichnet,**
**dass** die erste elektronische Schaltung (4, 6) eine zwei- oder mehrstufige LogikSchaltung zur logischen Verknüpfung von zwei oder mehr Taktsignalen, insbesondere drei oder mehr Taktsignalen ist.

9. Elektronikbaugruppe (10) nach einem der vorgehenden Ansprüche,
**dadurch gekennzeichnet,**
**dass** die erste elektronische Schaltung (4, 6) ein oder mehr Speicherelemente (41, 42, 43, 44) aufweist, die mittels eines zugeordneten Taktsignals ausgelesen werden.

10. Elektronikbaugruppe (10) nach einem der vorgenannten Ansprüche,
**dadurch gekennzeichnet,**
**dass** die Elektronikbaugruppe (10) ein flexibles Folienelement ist, welches als Sicherungselement, insbesondere für Wertdokumente und Waren, ausgebildet ist.

11. Elektronikbaugruppe (10) nach einem der vorgenannten Ansprüche,
**dadurch gekennzeichnet,**
**dass** die Elektronikbaugruppe (10) weiter eine Antenne und einen mit der Antenne gekoppelten Modulator als zweite elektronische Schaltung (13) aufweist, wobei ein Steuer-Eingang der zweiten elektronischen Schaltung (13) mit einem Ausgang der ersten elektronischen Schaltung (4, 6) verbunden ist.

12. Elektronikbaugruppe (10) nach einem der vorangehenden Ansprüche,
**dadurch gekennzeichnet,**
**dass** die erste elektronische Schaltung (4, 6) organische Bauelemente aufweist.

## Claims

1. Electronic module (10) in the form of a multi-layer flexible film body, which includes a carrier film made of a plastics material and a plurality of electric functional layers, the electronic module (10) comprising a clock generator (2, 5) having n organic switching elements (21, 51) connected successively in series and each having at least a first and a complementary second input as well as at least a first and a complementary second output, the first and second outputs of each switching element (21, 51) being connected to the first and second inputs respectively of the successive organic switching element (21, 51), the first and second outputs of the n^{th} organic switching element (21, 51) being connected to the first and second inputs respectively of the first organic switching element (21, 51), and one or more outputs of one or more of the n organic switching elements (21, 51) of the clock generator (2, 5) being connected to respective inputs of a first electronic circuit (4, 6) of the electronic module (10) to tap one or more clock signals, **characterised in that** the organic switching elements (21, 51) are each composed of organic components, in particular of organic field-effect transistors, which are interconnected in such a way that two mutually inverted logic signals are generated at the first and second outputs based on a difference between the logic signals at the first and second inputs, each organic switching element (21, 51) comprising at least two switching units (81, 82), each having two inputs and at least one output, the switching units (81, 82) being formed from organic components, in particular by means of organic field-effect transistors, as logic circuits, and the two switching units (81, 82) being cross-coupled to one another in such a way that an output of one switching unit (81) is connected to an input of the other switching unit (82) and vice versa.

2. Electronic module (10) according to claim 1, **characterised in that** the clock generator (2, 5) and the first electronic circuit (4, 6) are interconnected in such a way that one or more first and/or second outputs of one or more of the n organic switching elements (21, 51) of the clock generator (2, 5) is/are connected to respective inputs of the first electronic circuit (4, 6) of the electronic module (10) to tap one or more clock signals.

3. Electronic module (10) according to claim 2, **characterised in that** the clock generator (2, 5) and the first electronic circuit (4, 6) are interconnected in such a way that first clock signals for the first electronic circuit (4, 6) are tapped at the first and/or second output (31, 52) of a first of the organic switching elements (21, 51), and second clock signals, which are phase-shifted compared to the first clock signals, for the first electronic circuit (4, 6) are tapped at the first and/or second output (32, 33, 34, 35, 53) of a second switching element (21, 51), which is different from the first switching element.

4. Electronic module (10) according to either claim 2 or claim 3, **characterised in that** both one or more first outputs and one or more second outputs of the organic switching elements of the clock generator (2, 5) are connected to respective inputs of the first electronic circuit (4, 6) of the electronic module (10) to tap one or more clock signals.

5. Electronic module according to any one of clams 1 to 4, **characterised in that** an internal switching signal of at least one of the organic switching elements of the clock generator is connected as a further output signal and via a further output of the at least one organic switching element to the respective input of the first electronic circuit of the electronic module to tap one or more clock signals.

6. Electronic module according to any one of the preceding claims, **characterised in that** one or more of the organic switching elements comprise(s) a further input for feeding a release signal or a block signal.

7. Electronic module (10) according to any one of the preceding claims, **characterised in that** the first electronic circuit (4, 6) comprises one or more logic gates composed of organic components, said gates logically coupling the two or more fed clock signals to an output signal.

8. Electronic module (10) according to any one of the preceding claims, **characterised in that** the first electronic circuit (4, 6) is a two- or multi-stage logic circuit for logically coupling two or more clock signals, in particular three or more clock signals.

9. Electronic module (10) according to any one of the preceding claims, **characterised in that** the first electronic circuit (4, 6) comprises one or more memory elements (41, 42, 43, 44), which are read by means of an assigned clock signal.

10. Electronic module (10) according to any one of the preceding claims, **characterised in that** the electronic module (10) is a flexible film element which is formed as a security element, in particular for value documents and goods.

11. Electronic module (10) according to any one of the preceding claims, **characterised in that** the electronic module (10) further comprises an antenna and a modulator coupled to the antenna as a second electronic circuit (13), a control input of the second electronic circuit (13) being connected to an output of the first electronic circuit (4, 6).

12. Electronic module (10) according to any one of the preceding claims, **characterised in that** the first electronic circuit (4, 6) comprises organic components.

## Revendications

1. Bloc électronique (10) sous la forme d'un corps de film flexible multicouche, qui comporte une plaque support en un matériau synthétique et plusieurs couches fonctionnelles électriques, sachant que le bloc électronique (10) présente un générateur de cadence (2, 5) doté de n éléments de commutation (21, 51) organiques commutés en série les uns derrière les autres avec respectivement au moins une première entrée et une deuxième entrée complémentaire ainsi qu'au moins une première sortie et une deuxième sortie complémentaire, sachant que la première sortie et la deuxième sortie de chaque élément de commutation (21, 51) sont reliées à la première entrée ou à la deuxième entrée de l'élément de commutation (21, 51) organique qui suit, sachant que la première sortie et la deuxième sortie de l'énième élément de commutation (21, 51) organique sont reliées à la première entrée ou à la deuxième entrée du premier élément de commutation (21, 51) organique, et sachant qu'une ou plusieurs sorties d'un ou de plusieurs énièmes éléments de commutation (21, 51) organiques du générateur de cadence (2, 5) sont reliées respectivement aux sorties d'un premier circuit électronique (4, 6) du bloc électronique (10) pour prélever un ou plusieurs signaux de cadence,
**caractérisé en ce**
**que** les éléments de commutation (21, 51) organiques sont construits respectivement à partir de composants organiques, en particulier à partir de transistors à effet de champ organiques, lesquels sont commutés entre eux de telle manière que deux signaux logiques inversés l'un par rapport à l'autre sont générés au niveau de la première sortie ou au niveau de la deuxième sortie sur la base d'une différence entre les signaux logiques se trouvant au niveau de la première entrée et au niveau de la deuxième entrée, sachant que chaque élément de commutation (21, 51) organique présente au moins deux unités de commutation (81, 82) dotées respectivement de deux entrées et au moins d'une sortie, sachant que les unités de commutation (81, 82) sont réalisées comme des circuits logiques à partir de composants organiques, en particulier avec des transistors à effet de champ organiques, et que les deux unités de commutation (81, 82) sont couplées en croix entre elles de telle manière qu'une sortie d'une unité de commutation (81) est reliée à une entrée de l'autre unité de commutation (82) et inversement.

2. Bloc électronique (10) selon la revendication 1,
**caractérisé en ce**
**que** le générateur de cadence (2, 5) et le premier circuit électronique (4, 6) sont commutés ensemble de telle manière qu'une ou plusieurs premières et/ou deuxièmes sorties d'un ou de plusieurs n éléments de commutations (21, 51) organiques du générateur de cadence (2, 5) sont reliées aux entrées respectives du premier circuit électronique (4, 6) du bloc électronique (10) pour prélever un ou plusieurs signaux de cadence.

3. Bloc électronique (10) selon la revendication 2,
**caractérisé en ce**
**que** le générateur de cadence (2, 5) et le premier circuit électronique (4, 6) sont reliés entre eux de telle manière que des premiers signaux de cadence pour le premier circuit électronique (4, 6) sont prélevés au niveau de la première sortie et/ou de la deuxième sortie (31, 52) d'un premier élément de commutation parmi les éléments de commutation (21, 51) organiques, et en ce que des deuxièmes signaux de cadence décalés en phase par rapport aux premiers signaux de cadence sont prélevés pour le premier circuit électronique (4, 6) au niveau de la première et/ou de la deuxième sortie (32, 33, 34, 35, 53) d'un deuxième élément de commutation (21, 51) se distinguant du premier élément de commutation.

4. Bloc électronique (10) selon la revendication 2 ou 3,
**caractérisé en ce**
**qu'**aussi bien une ou plusieurs premières sorties qu'une ou plusieurs deuxièmes sorties des éléments de commutation organiques du générateur de cadence (2, 5) sont reliées aux entrées respectives du premier circuit électronique (4, 6) du bloc électronique (10) pour prélever un ou plusieurs signaux de cadence.

5. Bloc électronique selon l'une quelconque des revendications 1 à 4,
**caractérisé en ce**
**qu'**un signal de commutation interne d'au moins un des éléments de commutation organiques du générateur de cadence est relié en tant qu'autre signal de sortie à une entrée respective du premier circuit électronique du bloc électronique par l'intermédiaire d'une autre sortie de l'élément de commutation organique au moins au nombre de un pour prélever un ou plusieurs signaux de cadence.

6. Bloc électronique selon l'une quelconque des revendications précédentes,
**caractérisé en ce**
**qu'**un ou plusieurs éléments de commutation organiques présentent une autre entrée pour introduire un signal de déblocage ou de blocage.

7. Bloc électronique (10) selon l'une quelconque des revendications précédentes,
**caractérisé en ce**
**que** le premier circuit électronique (4, 6) présente une ou plusieurs grilles logiques construites à partir de composants organiques, lesquelles rapprochent de manière logique deux signaux de cadence imprimés ou plus pour former un signal de sortie.

8. Bloc électronique (10) selon l'une quelconque des revendications précédentes,
**caractérisé en ce**
**que** le premier circuit électronique (4, 6) est un circuit logique à deux étages ou plus pour le rapprochement logique de deux signaux de cadence ou plus, en particulier de trois signaux de cadence ou plus.

9. Bloc électronique (10) selon l'une quelconque des revendications précédentes,
**caractérisé en ce**
**que** le premier circuit électronique (4, 6) présente un élément accumulateur (41, 42, 43, 44) ou plus, qui sont triés au moyen d'un signal de cadence attribué.

10. Bloc électronique (10) selon l'une quelconque des revendications précédentes,
**caractérisé en ce**
**que** le bloc électronique (10) est un élément de film flexible, qui est réalisé comme un élément de sécurité, en particulier pour des documents de valeur et des marchandises.

11. Bloc électronique (10) selon l'une quelconque des revendications précédentes,
**caractérisé en ce**
**que** le bloc électronique (10) présente en outre comme deuxième circuit électronique (13), une antenne et un modulateur couplé à l'antenne, sachant qu'une entrée de commande du deuxième premier circuit électronique (13) est reliée à une sortie du premier circuit électronique (4, 6).

12. Bloc électronique (10) selon l'une quelconque des revendications précédentes,
**caractérisé en ce**
**que** le premier circuit électronique (4, 6) présente des composants organiques.
